# EUROPEAN PATENT APPLICATION

(11) **EP 1 710 844 A1**
(43) Date of publication of application: **11.10.2006**
(21) Application number: 04808044.4
(22) Date of filing: 22.12.2004
(51) Int. Cl.: H01L 31/0336, H01L 27/142

(54) **INTEGRATED THIN-FILM SOLAR CELL AND ITS MANUFACTURING METHOD**

(30) Priority: 25.12.2003 JP 2003428811
(71) Applicant: Showa Shell Sekiyu Kabushiki Kaisha, Minato-ku Tokyo 1358074 (JP)
(72) Inventor: KUSHIYA, Katsumi, c/o Showa Shell Sekiyu K.K., Minato-ku, Tokyo 1358074 (JP); TACHIYUKI, Muneyori, c/o Showa Shell Sekiyu K.K., Minato-ku, Tokyo 1358074 (JP)
(74) Representative: HOFFMANN EITLE
(86) International application number: PCT/JP2004/019693
(87) International publication number: WO 2005/064693

(57) **Abstract**

A problem of the invention is to prevent a substrate from being damaged with a metal stylus upon mechanical patterning.

In the invention, a thin film obtained by accumulating in this order a substrate 2, a back surface electrode layer 3, a multi-element compound semiconductor thin film (light absorbing layer) 5, a transparent buffer layer 6 having a high resistance and a transparent and electroconductive window layer 7 is divided into respective unit cells, which are connected plurally in series to obtain a prescribed voltage, and it contains patterning P1 of dividing the back surface electrode layer 3, patterning P2 of dividing the light absorbing layer 5, or the light absorbing layer and the buffer layer 6, and patterning P3 of dividing from the window layer 7 up to the light absorbing layer 5, in which in P2 and P3, an ultrathin film layer 4 formed secondarily through reaction with a chalcogen element on the surface of the back surface electrode layer 3 in the formation step of the light absorbing layer is used as a solid lubricant upon mechanically removing the constitutional thin film layers with a metal stylus to form grooves.

## Description

### TECHNICAL FIELD

The present invention relates to an integrated thin-film solar cell, in which constitutional thin films are divided into respective thin-film solar unit cells and their thin-film solar unit cells are connected in series by patterning steps in order to obtain a prescribed voltage, and to a process for producing the same.

### BACKGROUND ART

In the production of a solar cell module, it is necessary that a prescribed number of solar cells, as basic units, are connected in series to obtain a prescribed voltage, and in the case of a crystalline silicon solar cell, a stringing step is required for connecting alternately the front surfaces and the back surfaces of the solar cells with copper ribbons with solder. In a thin-film solar cell, such as a CIS type one, on the other hand, such a production process is employed that plural solar cells are divided by patterning on a substrate and are connected in series to form an integrated structure.

As a p-type light absorbing layer of a CIS thin-film solar cell, a Cu-III-VI₂ chalcopyrite semiconductor, such as copper indium diselenide (CIS), copper indium gallium diselenide (CIGS), copper indium gallium diselenide sulfide (CIGSS), CIGS having a thin film layer of CIGSS as a surface layer, and the like have been known, and an integrated thin-film solar cell having the p-type light absorbing layer and a pn-hetero junction is divided into plural unit cells in a strip shape to form grooves or gaps of several tens to several hundreds micrometers as an interconnecting part. In the production step for connecting the unit cells in series, a patterning step is employed (as described, for example, in Non-patent Document 1 and Patent Document 1).
Non-patent Document 1: C. Fredric, et al., The 23th IEEE Photovoltaic Specialist Conference (1993), pp. 437 to 440 Patent Document 1: JP-A-2002-319686

The production process of the integrated thin-film solar cell comprises, for example, three patterning steps P1, P2 and P3. In the patterning P1, ametalbackelectrode layer of molybdenum or the like is formed on an insulating substrate by a sputtering method, and then the metal back electrode layer is divided into a strip shape by using an infrared (1, 064 nm) beam, such as neodymium YAG laser. A p-type light absorbing layer formed of a Cu-III-VI₂ chalcopyrite semiconductor is formed thereon by a simultaneous vapor deposition method or a selenide method, and then a buffer layer formed of a transparent compound semiconductor thin film having a high resistance is formed by chemically growing from a solution to form a semiconductor thin film having an accumulated structure. In the patterning P2, the semiconductor thin film, i.e., the buffer layer and the p-type light absorbing layer, is divided into a strip shape by mechanically removing a part thereof by a mechanical scribing method. In the patterning P2, the film is divided into the same number as the number of the unit cells divided in the patterning P1 with a positional offset. The patterning P3 is attained in such a manner that a transparent electroconductive film (window layer) formed of a metal oxide semiconductor thin film is formed on the buffer layer, and then the transparent electroconductive film (window layer), the buffer layer and the p-type light absorbing layer are partially removed mechanically by a mechanical scribing method with an offset with respect to the position in the patterning P2, so as to divide them into a strip shape. As a result, solar cells each having an accumulated structure having the metal back electrode layer having accumulated thereon in this order the p-type light absorbing layer, the buffer layer and the transparent electroconductive film (window layer) are divided into cell units, and the transparent electroconductive film (window layer) of the solar cell is connected in series to the metal back electrode layer of the adjacent solar cell.

In the patterning step of dividing a part of a thin film by a mechanical scribing method employed in the conventional production process of an integrated thin-film solar cell, a metallic blade, a cutter knife, a metal stylus or needle, or the like is used as a measure for dividing the thin film. For example, in the case where a metal stylus capable of dividing precisely is used, it is necessary in the patterning step that the thin films of from the buffer layer to the light absorbing layer, or from the transparent electroconductive film (window layer) to the light absorbing layer are respectively divided, and such a problem arises thereon that the metal stylus penetrates through the metal back electrode layer as an underlayer of the light absorbing layer to expose the glass surface of the substrate.

### DISCLOSURE OF THE INVENTION

The invention is to solve the aforementioned problems, and an object of the invention is that in a series of a production process of a thin-film solar cell having an accumulated structure containing plural thin-film solar cells in a prescribed number connected in series on a substrate, a patterning step for dividing the thin-film solar cells and connecting them is incorporated, whereby the production process is simplified, the production cost is considerably reduced, and the yield is improved with the conversion efficiency of the thin-film solar cell maintained.

Furthermore, the invention is that in a mechanical scribing method employed in the production process of the integrated thin-film solar cell, a metal stylus is used, whereby the solar cell is produced easily at a low equipment cost in a short period of time.

Furthermore, the invention is that an ultrathin film layer 4 formed as a by-product at a boundary between a metal back electrode layer 3 and a light absorbing layer 5 is utilized as a solid lubricant, whereby a glass surface of a substrate is prevented from being exposed due to penetration of the metal stylus through the metal back electrode layer as an underlayer of the light absorbing layer in a patterning step for dividing a part of the thin films by the mechanical scribing method into a strip shape, and thus the yield of the product is prevented from being decreased.
(1) The invention is an integrated thin-film solar cell comprising a substrate and constitutional thin films containing a metal back electrode layer on the substrate, a multi-element compound semiconductor thin film having a p-type conductivity and being provided as a light absorbing layer on the metal back electrode layer (hereinafter, referred to as a light absorbing layer), a metal oxide semiconductor thin film having an opposite type conductivity against the multi-element compound semiconductor thin film, having a wider bandgap, being transparent, having electroconductivity, and being provided as a window layer for the multi-element compound semiconductor thin film (hereinafter, referred to as a window layer), and a buffer layer containing a mixed crystal compound semiconductor thin film at an interface between the light absorbing layer and the window layer,
   wherein an ultrathin film layer formed secondarily at a boundary between the metal back electrode layer and the light absorbing layer upon forming the light absorbing layer on the metal back electrode layer is utilized as a solid lubricant in subsequent patterning steps to provide such a structure that the constitutional thin films are divided into thin-film solar unit cells and a plurality of the thin-film solar unit cells are connected by patterning.
(2) The invention is the integrated thin-film solar cell according to the above (1), wherein in a case where the metal back electrode layer is molybdenum, the ultrathin film layer comprises molybdenum selenide or molybdenum sulfide.
(3) The invention is a process for producing an integrated thin-film solar cell comprising a substrate and constitutional thin films containing a metal back electrode layer on the substrate, a multi-element compound semiconductor thin film having a p-type conductivity and being provided as a light absorbing layer on the metal back electrode layer, a metal oxide semiconductor thin film having an opposite type conductivity against the multi-element compound semiconductor thin film, having a wider bandgap, being transparent, having electroconductivity, and being provided as a window layer on the multi-element compound semiconductor thin film, and a buffer layer containing a mixed crystal compound semiconductor thin film at an interface between the light absorbing layer and the window layer,
   wherein the process comprises a first patterning step of patterning (forming a pattern) by removing a part of the metal back electrode layer in a thin line form,
   a second patterning step of patterning (forming a pattern) by removing a part of the light absorbing layer or a part of the light absorbing layer and the buffer layer in a thin line form with a prescribed offset with respect to the pattern formed in the first patterning step as a reference position, and
   a third patterning step of patterning (forming a pattern) by removing a part of the light absorbing layer, the buffer layer and the window layer in a thin line form with a prescribed offset with respect to the pattern formed in the first patterning step or the second patterning step as a reference position,
   wherein the second patterning step and the third patterning step are conducted by a mechanical scribing method of removing a part of a target accumulated thin film layer by mechanically scribing with a metal stylus having a pointed tip end, in which the tip end of the metal stylus is slid to remove the layers up to the light absorbing layer by mechanically scribing, using an ultrathin film layer formed secondarily on a surface of the metal back electrode layer upon forming the light absorbing layer as a solid lubricant, and
   wherein the first patterning step, the second patterning step and the third patterning step are conducted in this order, so as to remove mechanically the constitutional thin film layers of the target thin-film solar cell and to form grooves or gaps for dividing the thin-film solar cell into unit cells in a strip shape, whereby an integrated thin-film solar cell having a structure containing a prescribed number of the divided unit cells being connected in series is obtained.
(4) The invention is the process for producing an integrated thin-film solar cell according to the above (3), wherein in a case where the metal back electrode layer is a metal, such as molybdenum, the first patterning step is conducted by a laser method.
(5) The invention is the process for producing an integrated thin-film solar cell according to the above (3), wherein in a case where the metal back electrode layer is molybdenum, the ultrathin film layer formed secondarily on the surface of the metal back electrode layer is molybdenum selenide or molybdenum sulfide.
(6) The invention is the process for producing an integrated thin-film solar cell according to the above (3), wherein the grooves or gaps formed in the second patterning step and the third patterning step have a width of from 30 to 50 µm and a length of 1 m or more, have good linearity, and are formed plurally with close positional relationship.

In the invention, in a series of a production process of a thin-film solar cell having an accumulated structure containing plural thin film solar cells in a prescribed number connected in series on a substrate, a patterning step for dividing the thin film solar cells and connecting them is incorporated, whereby the production process can be simplified, the production cost can be considerably reduced, and the yield can be improved with the conversion efficiency of the thin-film solar cell maintained.

In the invention, furthermore, in a mechanical scribing method employed in the production process of the integrated thin-film solar cell, a metal stylus is used, whereby the solar cell can be produced easily at a low equipment cost in a short period of time.

In the invention, furthermore, an ultrathin film layer 4 formed secondarily at a boundary between a metal back electrode layer 3 and a light absorbing layer 5 is utilized as a solid lubricant, whereby a glass surface of a substrate can be prevented from being exposed due to penetration of the metal stylus through the metal back electrode layer as an underlayer of the light absorbing layer in a patterning step for dividing a part of the thin films by the mechanical scribing method into a strip shape, and as a result, the yield of the product can be prevented from being decreased.

### BRIEF DESCRIPTION OF THE DRAWINGS

Fig. 1 is (a) a conditional view (cross sectional view) after conducting patterning P1 in the process for producing an integrated thin-film solar cell of the invention, (b) a conditional view (cross sectional view) after conducting patterning P2 in the process for producing an integrated thin-film solar cell of the invention, and (c) a conditional view (cross sectional view) after conducting patterning P3 in the process for producing an integrated thin-film solar cell of the invention.
Fig. 2 is a view showing a basic structure of the integrated thin-film solar cell of the invention.
Fig. 3 is a view showing a patterned state of an integrated thin-film solar cell formed by patterning P1, P2 and P3 in the process for producing an integrated thin-film solar cell of the invention.
Fig. 4 is a view observed with a transmission electron microscope showing a state of an ultrathin film layer (molybdenum selenide formed in the case where the metal back electrode layer is molybdenum) functioning as a solid lubricant in the integrated thin-film solar cell of the invention.
Fig. 5 is a comparative view of conversion efficiency between a thin-film solar cell applied with patterning P2 before forming a buffer layer and a thin-film solar cell applied with patterning P2 after forming a buffer layer, in an integrated thin-film solar cell produced by the process for producing an integrated thin-film solar cell of the invention.

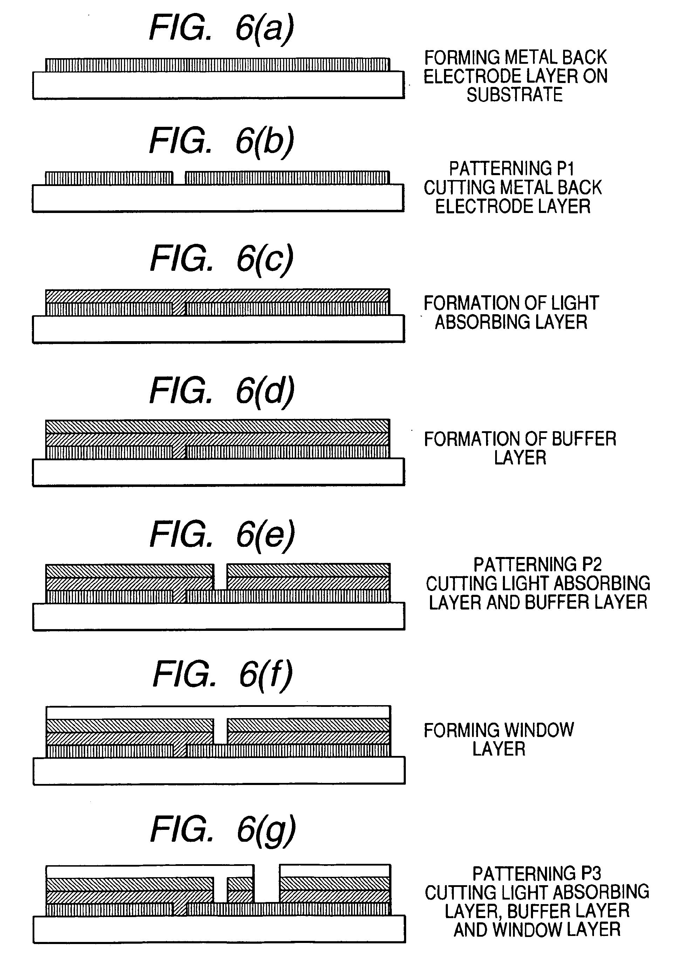

Fig. 6 is a view (cross sectional view) showing an order of patterning steps in the conventional process for producing an integrated thin-film solar cell.

In the figures, numeral 1 denotes a thin-film solar cell, 2 denotes a substrate, 3 denotes a metal back electrode, 4 denotes an ultrathin film layer (solid lubricant layer), 5 denotes a light absorbing layer (p-type multi-element semiconductor thin film), 6 denotes a buffer layer (mixed crystal compound semiconductor film), and 7 denotes a window layer (n-type transparent electroconductive film).

### BEST MODE FOR CARRYING OUT THE INVENTION

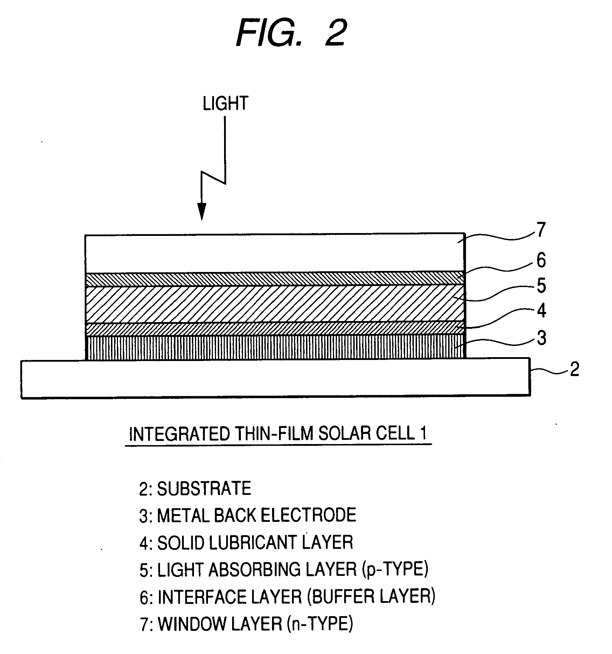

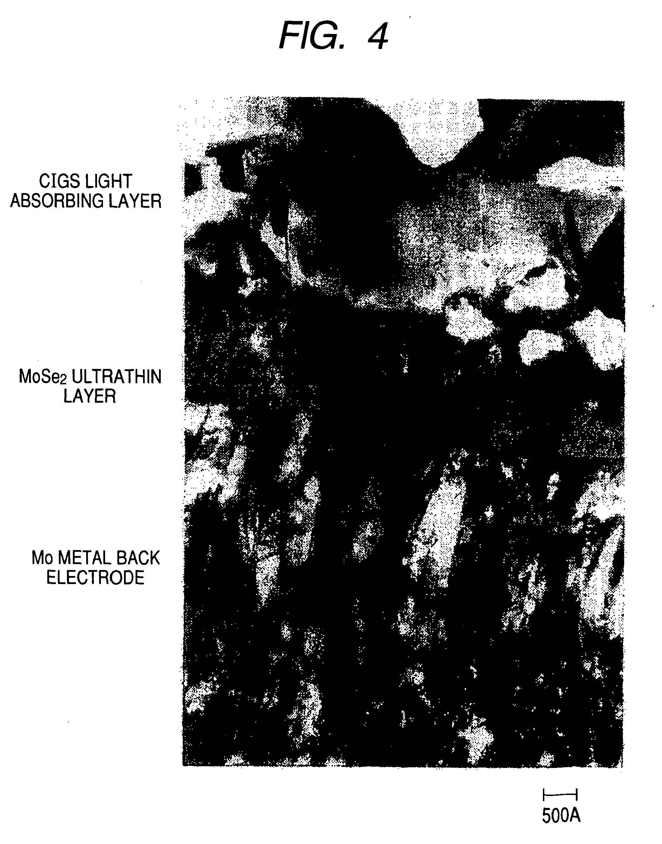

The basic structure of the integrated thin film solar cell of the invention is, as shown in Fig. 2, an integrated thin-film solar cell 1 having an accumulated layer structure containing a substrate 2 and constitutional thin films containing a metal back electrode layer 3 on the substrate 2, an multi-element compound semiconductor thin film 5 having a p-type conductivity and being provided as alight absorbing layer on the metal back electrode layer 3, a metal oxide semiconductor thin film 7 having an opposite type conductivity against the multi-element compound semiconductor thin film 5, having a wider bandgap, being transparent, having electroconductivity, and being provided as a window layer on the multi-element compound semiconductor thin film 5, and a buffer layer 6 containing a mixed crystal compound semiconductor thin film having a high resistance at an interface between the light absorbing layer 5 and the window layer 7. An ultrathin film layer 4 is formed secondarily at a boundary between the metal back electrode layer 3 and the light absorbing layer 5 upon forming the light absorbing layer 5 on the metal back electrode layer 2. In the invention, the ultrathin film layer 4 is utilized as a solid lubricant in a patterning step for dividing into the thin-film solar unit cells and connecting a plurality of the thin film solar unit cells. In the case where the metal back electrode layer is molybdenum, the ultrathin film layer 4 is molybdenum selenide or molybdenum sulfide. In the case of the ultrathin film layer 4 is molybdenum selenide, the thickness thereof is from 100 to 200 nm (from 0.1 to 0.2 µm) as shown in Fig. 4.

The light absorbing layer 5 is formed of a Cu-III-VI₂ chalcopyrite semiconductor, such as copper indium diselenide (CIS), copper indium galliumdiselenide (CIGS), copper indium gallium diselenide sulfide (CIGSS), CIGS having a thin film layer of CIGSS as a surface layer, and the like.

The process for producing an integrated thin-film solar cell having an accumulated structure of the invention will be described.

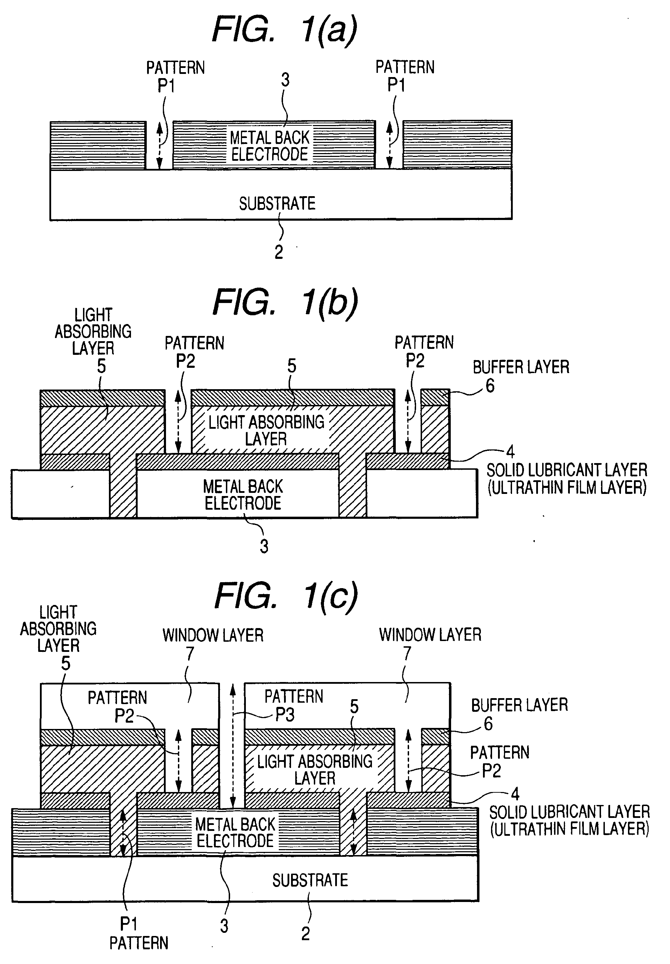

In the process for producing an integrated thin- film solar cell of the invention, as shown in Fig. 1, in a series of a production process of a thin-film solar cell having an accumulated structure containing plural thin film solar cells in a prescribed number connected in series on a substrate, three patterning steps (pattern forming steps) P1, P2 and P3 for dividing the thin-film solar cells and connecting them are incorporated, whereby the production process of a solar cell having a high conversion efficiency can be attained.

In the patterning P1 as a first pattern forming step, as shown in Fig. 1(a), a metal back electrode layer 3 formed of a metal, such as molybdenum, is formed on an insulating substrate 2 formed of glass or the like by a sputtering method, and then the metal back electrode layer is divided into a strip shape by using a laser beam. In the case where the metal back electrode layer is formed of a metal, such as Mo, the laser method is suitable for the patterning P1.

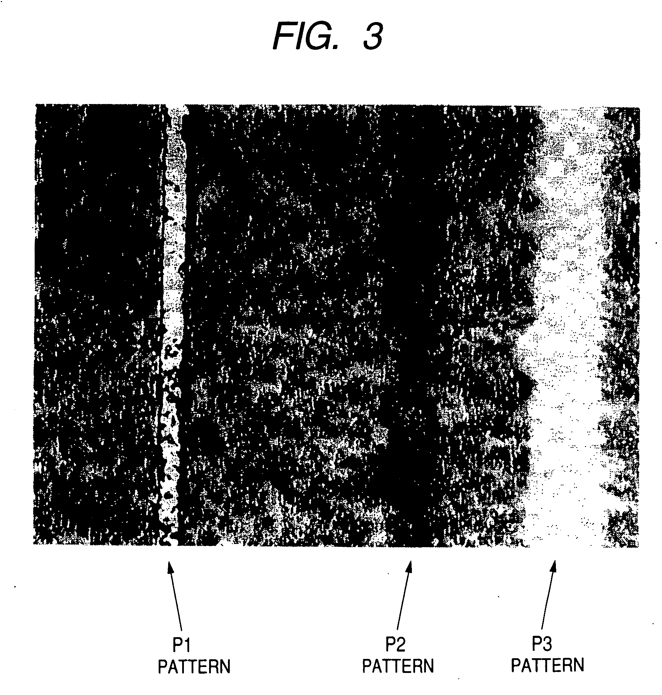

In the patterning P2 as a second pattern forming step, as shown in Fig. 1(b), after a p-type light absorbing layer 5 formed of a Cu-III-VI₂ chalcopyrite semiconductor is formed on the metal back electrode layer 3 having been subjected to the patterning P1 by a simultaneous vapor deposition method or a selenide method (i.e., before forming a buffer layer), or after the p-type light absorbing layer 5 is formed, and a buffer layer 6 formed of a transparent compound semiconductor thin film having a high resistance is formed to provide a semiconductor thin film having an accumulated structure (i.e., after forming a buffer layer), the p-type light absorbing layer 5, or the buffer layer 6 and the p-type light absorbing layer 5 are divided into a strip shape by mechanically removing a part thereof by a mechanical scribing method. In the patterning P2, as shown in Fig. 3, the film is patterned into the same number as the number of the unit cells divided in the patterning P1 with a positional offset.

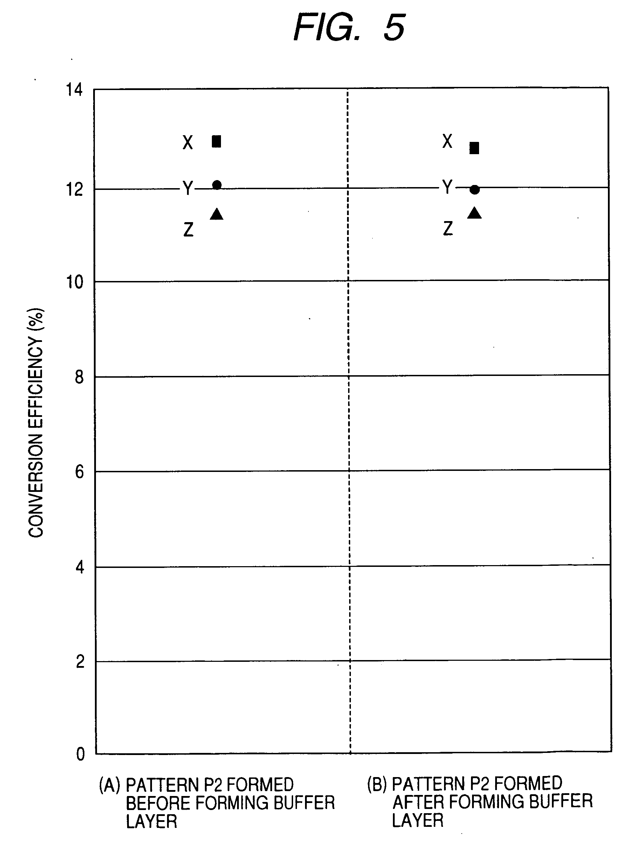

As compared to the case (A) where the pattering P2 is conducted after forming the light absorbing layer 5 (i.e., before forming the buffer layer) and the case (B) where it is conducted after forming the light absorbing layer 5 and the buffer layer 6 (i.e., after forming the buffer layer), there is no difference in conversion efficiency of the thin-film solar cell between the case where it is conducted before forming the buffer layer and the case where it is conducted after forming the buffer layer as shown in Fig. 5, and therefore, the patterning P2 may be conducted either before forming the buffer layer or after forming the buffer layer. As a result, the degree of freedom in the patterning P2 is increased to enable formation of a window layer without a drying step after forming the buffer layer, whereby reduction in cost and simplification of operation can be attained.

The patterning P3 is attained in such a manner that, as shown in Fig. 1(c), a transparent electroconductive film formed of a metal oxide semiconductor thin film provided as a window layer 6 is formed on the buffer layer 6, and then the window layer 6, the buffer layer 6 and the p-type light absorbing layer 5 are partially removed mechanically by a mechanical scribing method using a metal stylus or the like with an offset with respect to the position in the patterning P1 or the patterning P2, so as to divide them into a strip shape. As a result, solar cells each having an accumulated structure having the metal back electrode layer 3 having accumulated thereon in this order the p-type light absorbing layer 5, the buffer layer 6 and the window layer 7 are divided into cell units, and the window layer 7 of the solar cell is connected in series to the metal back electrode layer 3 of the adjacent solar cell.

Upon reacting a chalcogen element (such as selenium and sulfur) with the metal back electrode layer 3 in the formation process of the light absorbing layer 5 formed of a multi-element semiconductor thin film, an ultrathin film layer 4 having a function of a solid lubricant is secondarily formed on the surface of the metal back electrode layer 3. In the case where the metal back electrode layer is molybdenum, the ultrathin film layer 4 is molybdenum selenide or molybdenum sulfide. In the invention, the ultrathin film layer 4 formed secondarily is positively used as a solid lubricant in the patterning P2 and P3 using a mechanical scribing method with a metal stylus to remove the layers up to the light absorbing layer 5 by mechanically scribing them by sliding the tip end of the metal stylus, whereby such a problem can be prevented from occurring that the metal stylus penetrates through the metal back electrode layer 3 to expose the glass surface as the substrate.

### EXAMPLE

Upon forming a pattern P2, the first groove formed in the patterning P1 is sought, and with the position thereof as a reference, the formation starting position of the first groove of the pattering P2 is determined by an offset operation. Upon forming a pattern P3, the first groove formed in the patterning P1 or the patterning P2 is sought, and with the position thereof as a reference, the formation starting position of the first groove of the pattering P3 is determined with a suitable offset.

Upon forming the pattern P2, the first groove formed in the patterning P1 is sought by using a CCD camera, and the reference line, which is the first groove formed in the patterning P1, and a groove formed in the patterning step of the patterning P2 are di splayed on a monitor screen, and the linearity in the patterning P2 is evaluated by comparing the reference line and the groove. Upon forming the pattern P3, the first groove formed in the patterning P1 or the patterning P2 is sought by using a CCD camera, and the reference line, which is the first groove formed in the patterning P1 or the patterning P2, and a groove formed in the patterning step of the patterning P3 are displayed on a monitor screen, and the linearity in the patterning P3 is evaluated by comparing the reference line and the groove. Furthermore, a scale is displayed on the monitor screen, and the linearity and the pattern width of the patterning P2 and the patterning P3 are measured based on the scale for evaluating them.

The application is based on the Japanese Patent Application filed on December 25, 2003 (Japanese Patent Application No. 2003-428811), contents of which are incorporated herein by reference.

### INDUSTRIAL APPLICABILITY

In the invention, in a series of a production process of a thin-film solar cell having an accumulated structure containing plural thin-film solar cells in a prescribed number connected in series on a substrate, a patterning step for dividing the thin-film solar cells and connecting them is incorporated, whereby the production process can be simplified, the production cost can be considerably reduced, and the yield can be improved with the conversion efficiency of the thin-film solar cell maintained.

In the invention, furthermore, in a mechanical scribing method employed in the production process of the integrated thin-film solar cell, a metal stylus is used, whereby the solar cell can be produced easily at a low equipment cost in a short period of time.

In the invention, furthermore, an ultrathin film layer 4 formed secondarily at a boundary between a metal back electrode layer 3 and a light absorbing layer 5 is utilized as a solid lubricant, whereby a glass surface of a substrate can be prevented from being exposed due to penetration of the metal stylus through the metal back electrode layer as an underlayer of the light absorbing layer in a patterning step for dividing a part of the thin films by the mechanical scribing method into a strip shape, and as a result, the yield of the product can be prevented from being decreased.

The invention has considerable industrial applicability owing to the aforementioned particular effects. The invention is not limited to the aforementioned embodiments.

## Claims

1. An integrated thin-film solar cell comprising a substrate and constitutional thin films comprising a metal back electrode layer on the substrate, a multi-element compound semiconductor thin film having a p-type conductivity and being provided as a light absorbing layer on the metal back electrode layer (hereinafter, referred to as a light absorbing layer), a metal oxide semiconductor thin film having an opposite type conductivity against the multi-element compound semiconductor thin film, having a wider bandgap, being transparent, having electroconductivity, and being provided as a window layer for the multi-element compound semiconductor thin film (hereinafter, referred to as a window layer), and a buffer layer comprising a mixed crystal compound semiconductor thin film at an interface between the light absorbing layer and the window layer,
wherein an ultrathin film layer formed secondarily at a boundary between the metal back electrode layer and the light absorbing layer upon forming the light absorbing layer on the metal back electrode layer is utilized as a solid lubricant in subsequent patterning steps to provide such a structure that the constitutional thin films are divided into thin-film solar unit cells and a plurality of the thin-film solar unit cells are connected by patterning.

2. The integrated thin-film solar cell according to claim 1, wherein in a case where the metal back electrode layer is molybdenum, the ultrathin film layer comprises molybdenum selenide or molybdenum sulfide.

3. A process for producing an integrated thin-film solar cell comprising a substrate and constitutional thin films containing a metal back electrode layer on the substrate, a multi-element compound semiconductor thin film having a p-type conductivity and being provided as a light absorbing layer on the metal back electrode layer, a metal oxide semiconductor thin film having an opposite type conductivity against the multi-element compound semiconductor thin film, having a wider bandgap, being transparent, having electroconductivity, and being provided as a window layer on the multi-element compound semiconductor thin film, and a buffer layer comprising a mixed crystal compound semiconductor thin film at an interface between the light absorbing layer and the window layer,
wherein the process comprises a first patterning step of patterning (forming a pattern) by removing a part of the metal back electrode layer in a thin line form,
a second patterning step of patterning (forming a pattern) by removing a part of the light absorbing layer or a part of the light absorbing layer and the buffer layer in a thin line form with a prescribed offset with respect to the pattern formed in the first patterning step as a reference position, and
a third patterning step of patterning (forming a pattern) by removing a part of the light absorbing layer, the buffer layer and the window layer in a thin line form with a prescribed offset with respect to the pattern formed in the first patterning step or the second patterning step as a reference position,
wherein the second patterning step and the third patterning step are conducted by a mechanical scribing method of removing a part of a target accumulated thin film layer by mechanically scribing with a metal stylus having a pointed tip end, in which the tip end of the metal stylus is slid to remove the layers up to the light absorbing layer by mechanically scribing, using an ultrathin film layer formed secondarily on a surface of the metal back electrode layer upon forming the light absorbing layer as a solid lubricant, and
wherein the first patterning step, the second patterning step and the third patterning step are conducted in this order, so as to remove mechanically the constitutional thin film layers of the target thin-film solar cell and to form grooves or gaps for dividing the thin-film solar cell into unit cells in a strip shape, whereby an integrated thin-film solar cell having a structure containing a prescribed number of the divided unit cells being connected in series is obtained.

4. The process for producing an integrated thin-film solar cell according to claim 3, wherein in a case where the metal back electrode layer is a metal, such as molybdenum, the first patterning step is conducted by a laser method.

5. The process for producing an integrated thin-film solar cell according to claim 3, wherein in a case where the metal back electrode layer is molybdenum, the ultrathin film layer formed secondarily on the surface of the metal back electrode layer is molybdenum selenide or molybdenum sulfide.

6. The process for producing an integrated thin-film solar cell according to claim 3, wherein the grooves or gaps formed in the second patterning step and the third patterning step have a width of from 30 to 50 µm and a length of 1 m or more, have good linearity, and are formed plurally with close positional relationship.
